# EUROPEAN PATENT APPLICATION

(11) **EP 4 543 176 A1**
(43) Date of publication of application: **23.04.2025**
(21) Application number: 24188608.4
(22) Date of filing: 15.07.2024
(51) Int. Cl.: H10K 59/124, H10K 59/131, H10K 59/88

(54) **DISPLAY DEVICE**

(30) Priority: 20.10.2023 KR 20230141512
(71) Applicant: Samsung Display Co., Ltd., Gyeonggi-do 17113 (KR)
(72) Inventor: Lee, Won Se, 17113 Yongin-si, Gyeonggi-do (KR); Park, Min Kyung, 17113 Yongin-si, Gyeonggi-do (KR); Sung, Seung Woo, 17113 Yongin-si, Gyeonggi-do (KR); Jang, Dong Hyeon, 17113 Yongin-si, Gyeonggi-do (KR); Jung, Su Kyo, 17113 Yongin-si, Gyeonggi-do (KR); Jo, Seung Han, 17113 Yongin-si, Gyeonggi-do (KR); Choi, Min Hee, 17113 Yongin-si, Gyeonggi-do (KR)
(74) Representative: Gulde & Partner

(57) **Abstract**

According to the disclosure, a display device includes a substrate including a display area and a non-display area, outer pixels positioned in the display area and positioned in a first direction from an edge of the substrate, dummy holes positioned in the non-display area and positioned between the edge of the substrate and the outer pixels, and a dummy line positioned in the non-display area and extending in a second direction different from the first direction between the dummy holes. The dummy line is positioned between a first insulating layer and a second insulating layer, and the dummy holes pass through the first insulating layer and the second insulating layer.

## Description

### BACKGROUND

### 1. FIELD

The disclosure relates to a display device.

### 2. DESCRIPTION OF THE RELATED ART

As information technology develops, importance of a display device, which is a connection medium between a user and information, has been highlighted. In response to this, a use of a display device such as a liquid crystal display device and an organic light emitting display device is increasing.

The display device may include a plurality of pixels and may display an image through the pixels. Each of the pixels may include a plurality of transistors. When hydrogen is diffused into a semiconductor configuring a channel of the transistor, the channel may become conductive and a threshold voltage of the transistor may change. Therefore, a problem that displaying an accurate image is difficult exists.

### SUMMARY

A technical feature to be solved is to provide a display device capable of preventing hydrogen diffusion into a transistor channel.

The invention is set out in the appended set of claims. According to an embodiment of the disclosure, a display device includes a substrate including a display area and a non-display area, outer pixels positioned in the display area and positioned in a first direction from an edge of the substrate, dummy holes positioned in the non-display area and positioned between the edge of the substrate and the outer pixels, and a dummy line positioned in the non-display area and extending in a second direction different from the first direction between the dummy holes. The dummy line is positioned between a first insulating layer and a second insulating layer, and the dummy holes pass through the first insulating layer and the second insulating layer. At least some of the dummy holes may not be holes for an electrical connection, but may function as a passage for hydrogen discharge. In other words, the dummy holes may be configured to prevent diffusion of hydrogen and discharge hydrogen to an outside. The dummy line may be positioned directly between the first insulating layer and the second insulating layer. For example, the dummy line may be positioned between the first insulating layer and the second insulating layer along a third direction arranged orthogonally with respect to the first direction and the second direction.

The display device may further include a third insulating layer positioned on the second insulating layer, and the dummy holes may include a portion of the third insulating layer therein. In other words, the dummy holes are at least partially filled with the portion of the third insulating layer. Accordingly, an electronical connection through the dummy holes may be prevented. The third insulating layer may be positioned directly on the second insulating layer.

The dummy holes may not include an electrode material therein. In other words, the dummy holes may be free of electrode material. Accordingly, an electronic connection caused by the dummy holes may be efficiently prevented.

One end of the dummy line may be connected to a first power line in an area adjacent to a first corner of the substrate, and an other end of the dummy line may be connected to the first power line in an area adjacent to a second corner of the substrate. The first and second corners of the substrate may be arranged oppositely, i.e. diagonally, or adjacently to each other.

Other portions of the dummy line except the one end of the dummy line and the other end of the dummy line may not be connected to the first power line. In other words, only both ends of the dummy line may be connected to the first power line.

The first power line may be positioned between the edge of the substrate and a dummy hole closest to the edge among the dummy holes, and may extend in the second direction. The first power line may be positioned directly between the edge of the substrate and the dummy hole closest to the edge among the dummy holes.

Each of the outer pixels may include transistors, and at least one of the transistors may be an oxide semiconductor transistor. An oxide semiconductor transistor has charge mobility lower than that of a polysilicon semiconductor transistor. Therefore, an amount of leakage current generated in a turn-off state of the oxide semiconductor transistor may be less than that of the polysilicon semiconductor transistors.

The oxide semiconductor transistor may be a transistor positioned most adjacent to the edge of the substrate among the transistors.

A scan line connected to the oxide semiconductor transistor may be positioned in a same electrode layer as the dummy line.

The oxide semiconductor transistor may be further connected to a sub-scan line that overlaps the scan line.

A distance between the scan line connected to the oxide semiconductor transistor and the substrate in a third direction arranged orthogonally with respect to the first direction and the second direction may be the largest among distances in the third direction between scan lines connected to the outer pixels and the substrate.

The dummy line DML may extend so as not to overlap the dummy holes in a third direction arranged orthogonally with respect to the first direction and the second direction. Accordingly, the dummy line may not be damaged when the dummy holes are etched.

The dummy holes may be configured to discharge hydrogen to an outside.

The display device may further comprise a first barrier layer and/or second barrier layer configured to block moisture and/or oxygen from entering from the outside.

The first barrier layer may be positioned between the substrate and a first electrode layer and/or the second barrier layer may be positioned between the first electrode layer and a fourth insulating layer.

According to an embodiment of the disclosure, a display device includes a substrate including a display area and a non-display area, outer pixels positioned in the display area and positioned in a first direction from an edge of the substrate, and a dummy line positioned in the non-display area and extending in a second direction different from the first direction between the edge of the substrate and the outer pixels. Each of the outer pixels includes transistors including at least one oxide semiconductor transistor, the oxide semiconductor transistor is a transistor positioned closest to the edge of the substrate among the transistors, and a scan line connected to the oxide semiconductor transistor and the dummy line are positioned in a same electrode layer.

A vertical distance between the scan line connected to the oxide semiconductor transistor and the substrate may be the largest among vertical distances between scan lines connected to the outer pixels and the substrate.

The oxide semiconductor transistor may be further connected to a sub-scan line, and the sub-scan line may be positioned to vertically overlap between the substrate and the scan line.

The display device may further include dummy holes positioned in the non-display area and positioned between the edge of the substrate and the outer pixels.

The dummy line may extend so as not to vertically overlap the dummy holes.

The dummy line may be positioned between a first insulating layer and a second insulating layer, and the dummy holes may pass through the first insulating layer and the second insulating layer.

The display device may further include a third insulating layer positioned on the second insulating layer, and the dummy holes may include a portion of the third insulating layer therein.

The dummy holes may not include an electrode material therein.

One end of the dummy line may be connected to a first power line in an area adjacent to a first corner of the substrate, and an other end of the dummy line may be connected to the first power line in an area adjacent to a second corner of the substrate.

The first power line may be positioned between the edge of the substrate and a dummy hole closest to the edge among the dummy holes, and may extend in the second direction.

The display device according to the disclosure may prevent hydrogen diffusion into a transistor channel.

### BRIEF DESCRIPTION OF THE DRAWINGS

The above and other features of the disclosure will become more apparent by describing in further detail embodiments thereof with reference to the accompanying drawings.
FIG. 1 is a diagram illustrating a display device according to an embodiment of the disclosure.
FIG. 2 is a diagram illustrating a pixel according to an embodiment of the disclosure.
FIG. 3 is a diagram illustrating a method of driving the pixel of FIG. 2.
FIGS. 4A, 4B, and 4C are diagrams illustrating a structure of a display panel according to an embodiment of the disclosure.
FIGS. 5, 6, 7, 8, 9, 10, 11, 12, 13, and 14 are diagrams illustrating a first area of a pixel unit according to an embodiment of the disclosure.
FIGS. 15A and 15B are cross-sectional views of a non-display area and a display area according to an embodiment of the disclosure.
FIG. 16 is a diagram illustrating a second area of a pixel unit according to an embodiment of the disclosure.
FIG. 17 is a diagram illustrating a third area of a pixel unit according to an embodiment of the disclosure.
FIGS. 18 and 19 are diagrams illustrating an effect of hydrogen diffusion prevention according to an embodiment of the disclosure.

### DETAILED DESCRIPTION OF THE EMBODIMENT

Hereinafter, various embodiments of the disclosure will be described in detail with reference to the accompanying drawings so that those skilled in the art may easily carry out the disclosure. The disclosure may be implemented in various different forms and is not limited to the embodiments described herein.

In order to clearly describe the disclosure, parts that are not related to the description are omitted, and the same or similar elements are denoted by the same reference numerals throughout the specification. Therefore, the above-described reference numerals may be used in other drawings.

In addition, sizes and thicknesses of each component shown in the drawings are arbitrarily shown for convenience of description, and thus the disclosure is not necessarily limited to those shown in the drawings. In the drawings, thicknesses may be exaggerated to clearly express various layers and areas.

In addition, an expression "is the same" in the description may mean "is substantially the same". That is, the expression "is the same" may be the same enough for those of ordinary skill to understand that it is the same. Other expressions may also be expressions in which "substantially" is omitted.

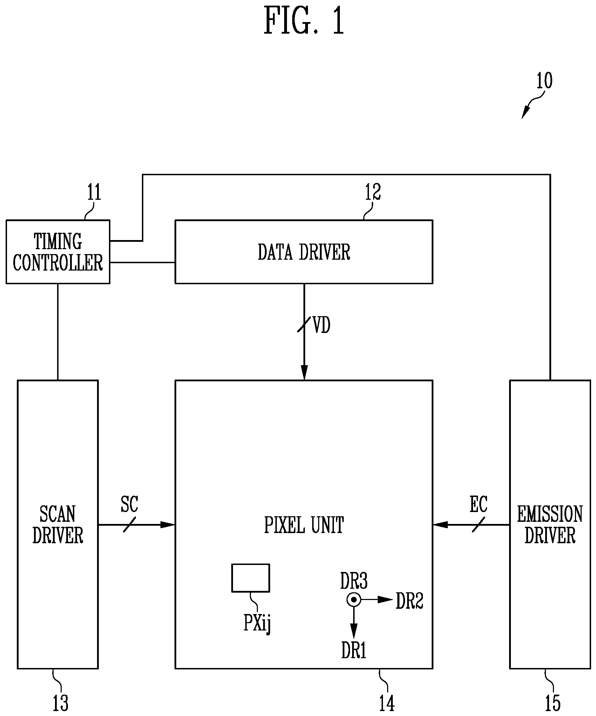

FIG. 1 is a diagram illustrating a display device 10 according to an embodiment of the disclosure.

Referring to FIG. 1, the display device 10 according to an embodiment of the disclosure may include a timing controller 11, a data driver 12, a scan driver 13, a pixel unit 14, and an emission driver 15.

The timing controller 11 may receive grayscales for an input image (or an input frame). The grayscales may include a first color grayscale, a second color grayscale, and a third color grayscale. The first color grayscale may be a grayscale for expressing a first color, the second color grayscale may be a grayscale for expressing a second color, and the third color grayscale may be a grayscale for expressing a third color.

In addition, the timing controller 11 may receive a control signal for an image. Such a control signal may include a horizontal synchronization signal (Hsync), a vertical synchronization signal (Vsync), and a data enable signal. The vertical synchronization signal may include a plurality of pulses, and may indicate that a previous frame period is ended and a current frame period is started based on a time point at which each of the pulses is generated. An interval between adjacent pulses of the vertical synchronization signal may correspond to one frame period. The horizontal synchronization signal may include a plurality of pulses, and may indicate that a previous horizontal period is ended and a new horizontal period is started based on a time point at which each of the pulses is generated. An interval between adjacent pulses of the horizontal synchronization signal may correspond to one horizontal period. The data enable signal may have an enable level with respect to specific horizontal periods and a disable level in remaining periods. When the data enable signal is at the enable level, the data enable signal may indicate that color grayscales are supplied in corresponding horizontal periods.

The timing controller 11 may provide grayscales rendered or corrected to correspond to a specification of the display device 10 to the data driver 12. In addition, the timing controller 11 may provide a clock signal, a scan start signal, and the like to the scan driver 13. The timing controller 11 may provide a clock signal, an emission stop signal, and the like to the emission driver 15.

The data driver 12 may generate data voltages VD to be provided to data lines using the grayscales and the control signals received from the timing controller 11. For example, the data driver 12 may sample the grayscales using the clock signal and apply the data voltages VD corresponding to the grayscales to the data lines in a pixel row unit. A pixel row refers to pixels connected to the same scan lines. The data lines may extend in a first direction DR1 on the pixel unit 14. The data lines may be arranged parallel to each other in a second direction DR2 perpendicular to the first direction DR1.

The scan driver 13 may receive the clock signal, the scan start signal, and the like from the timing controller 11 to generate scan signals SC to be provided to scan lines. The scan driver 13 may sequentially provide the scan signals SC having a turn-on level of pulse to the scan lines. For example, the scan driver 13 may be configured in a form of a shift register, and may generate the scan signals in a method of sequentially transferring a scan start signal of a pulse form of a turn-on level to a next stage circuit under control of the clock signal.

The scan driver 13 may include a plurality of sub-scan drivers according to a type of the scan signals SC. At this time, each of the plurality of sub-scan drivers may be configured in a form of a shift register. The scan lines may extend in the second direction DR2 on the pixel unit 14. The scan lines may be arranged parallel to each other in the first direction DR1.

The emission driver 15 may receive the clock signal, the emission stop signal, and the like from the timing controller 11 to generate emission signals EC to be provided to emission lines. The emission driver 15 may sequentially provide the emission signals EC having a turn-off level of pulse to the emission lines. For example, the emission driver 15 may be configured in a form of a shift register, and may generate the emission signals in a method of transferring the emission stop signal of a pulse form of a turn-off level to a next stage circuit under the control of the clock signal. The emission lines may extend in the second direction DR2 on the pixel unit 14. The emission lines may be arranged parallel to each other in the first direction DR1.

The pixel unit 14 may include first pixels emitting light of the first color, second pixels emitting light of the second color, and third pixels emitting light of the third color. The first color, the second color, and the third color may be different colors. For example, the first color may be one of red, green, and blue, the second color may be one other than the first color among red, green, and blue, and the third color may be one other than the first color and the second color among red, green, and blue. In addition, magenta, cyan, and yellow may be used instead of red, green, and blue as the first to third colors.

The pixel unit 14 may be disposed in various shapes such as diamond PENTILE^{™}, RGB-Stripe, S-stripe, Real RGB, and normal PENTILE^{™}.

The pixels of the pixel unit 14 may be positioned on a plane defined by the first direction DR1 and the second direction DR2. An emission direction may be a third direction DR3 perpendicular to the first direction DR1 and the second direction DR2.

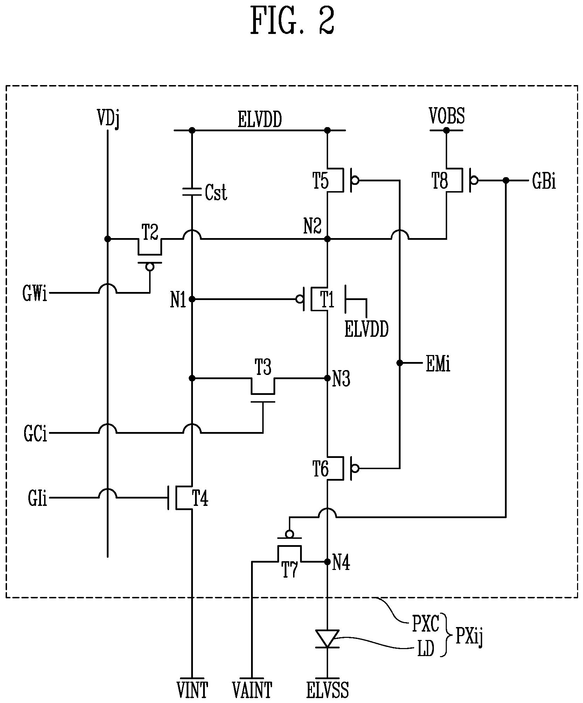

FIG. 2 is a diagram illustrating a pixel PXij according to an embodiment of the disclosure.

Referring to FIG. 2, the pixel PXij may include a pixel circuit PXC and a light emitting element LD. The pixel circuit PXC includes transistors T1, T2, T3, T4, T5, T6, T7, and T8 and a storage capacitor Cst. The pixel PXij may refer to a pixel connected to an i-th first scan line GWi and a j-th data line VDj. Each of i and j may be an integer greater than 0. A second scan line GCi, a third scan line Gli, a fourth scan line GBi, and an emission line EMi may be i-th lines. In an embodiment, at least one of the second scan line GCi, the third scan line Gli, the fourth scan line GBi, and the emission line EMi may not be the i-th line. For example, adjacent pixel rows may share one emission line EMi. In this case, the number of emission lines becomes less than the number of first scan lines.

Here, the pixel PXij may be the first pixel for expressing the first color. Since the second pixel for expressing the second color and the third pixel for expressing the third color may also be configured identically to the first pixel, an overlapping description is omitted.

In the present embodiment, P-type transistors may be polysilicon semiconductor transistors. In the polysilicon semiconductor transistor, a channel of an active layer may include a polysilicon semiconductor. For example, the polysilicon semiconductor transistor may be a low temperature poly-silicon (LTPS) thin film transistor. The polysilicon semiconductor transistor has high electron mobility and thus has a fast driving characteristic.

In the present embodiment, N-type transistors may be oxide semiconductor transistors. In the oxide semiconductor transistor, a channel of an active layer may include an oxide semiconductor. For example, the oxide transistor may be a low temperature polycrystalline oxide (LTPO) thin film transistor. The oxide semiconductor transistor has charge mobility lower than that of the polysilicon semiconductor transistor. Therefore, an amount of leakage current generated in a turn-off state of the oxide semiconductor transistor may be less than that of the polysilicon semiconductor transistors.

A gate electrode of the first transistor T1 may be connected to a first node N1, a first electrode may be connected to a second node N2, and a second electrode may be connected to a third node N3. The first transistor T1 may further include a sub-gate electrode (or a back gate electrode). The sub-gate electrode may receive a first power voltage ELVDD. The first transistor T1 may be a driving transistor. The first transistor T1 may be a P-type transistor.

A gate electrode of the second transistor T2 may be connected to the first scan line GWi, a first electrode may be connected to the data line VDj, and a second electrode may be connected to the second node N2. The second transistor T2 may be a scanning transistor. The second transistor T2 may be a P-type transistor.

A gate electrode of the third transistor T3 may be connected to the second scan line GCi, a first electrode may be connected to the first node N1, and a second electrode connected to the third node N3. The third transistor T3 may be a diode connection transistor. The third transistor T3 may be an N-type transistor. The third transistor T3 may further include a sub-gate electrode (or a back gate electrode).

A gate electrode of the fourth transistor T4 may be connected to the third scan line Gli, a first electrode may be connected to the first node N1, and a second electrode may receive a first initialization voltage VINT. The fourth transistor T4 may be a gate initialization transistor. The fourth transistor T4 may be an N-type transistor. The fourth transistor T4 may further include a sub-gate electrode (or a back gate electrode).

A gate electrode of the fifth transistor T5 may be connected to the emission line EMi, a first electrode may receive the first power voltage ELVDD, and a second electrode may be connected to the second node N2. The fifth transistor T5 may be a first emission control transistor. The fifth transistor T5 may be a P-type transistor.

A gate electrode of the sixth transistor T6 may be connected to the emission line EMi, a first electrode connected to the third node N3, and a second electrode connected to a fourth node N4. The sixth transistor T6 may be a second emission control transistor. The sixth transistor T6 may be a P-type transistor.

A gate electrode of the seventh transistor T7 may be connected to the fourth scan line GBi, a first electrode may receive a second initialization voltage VAINT, and a second electrode may be connected to the fourth node N4. The seventh transistor T7 may be an anode initialization transistor. The seventh transistor T7 may be a P-type transistor.

A gate electrode of the eighth transistor T8 may be connected to the fourth scan line GBi, a first electrode may receive a bias voltage VOBS, and a second electrode may be connected to the second node N2. The eighth transistor T8 may be a P-type transistor.

A first electrode of the storage capacitor Cst may receive the first power voltage ELVDD, and a second electrode may be connected to the first node N1.

An anode of the light emitting element LD may be connected to the fourth node N4, and a cathode may receive a second power voltage ELVSS. The light emitting element LD may emit light in one of the first color, the second color, and the third color. The light emitting element LD may be a light emitting diode. The light emitting element LD may be configured of an organic light emitting diode, an inorganic light emitting diode, a quantum dot/well light emitting diode, or the like. In the present embodiment, each pixel is provided with only one light emitting element LD, but in an embodiment, each pixel may be provided with a plurality of light emitting elements. At this time, the plurality of light emitting elements may be connected in series, parallel, series-parallel, or the like.

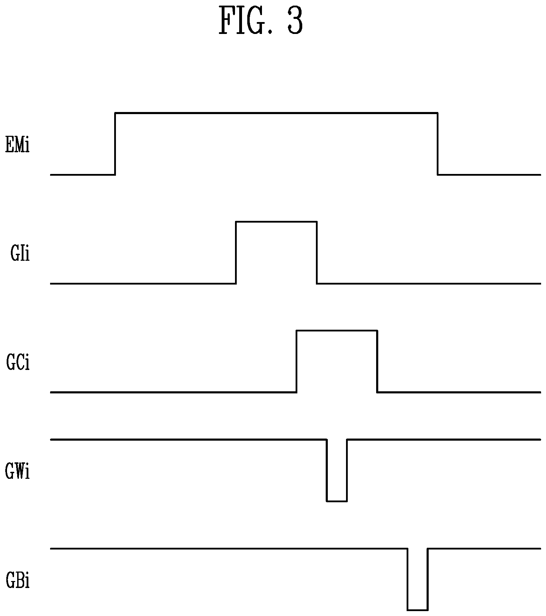

FIG. 3 is a diagram illustrating a method of driving the pixel PXij of FIG. 2.

First, a scan signal of a turn-off level (a high level) is applied to the emission line EMi, the fifth transistor T5 and the sixth transistor T6 are turned off, and thus the pixel PXij is in a non-emission state.

Next, a scan signal of a turn-on level (a high level) is applied to the third scan line Gli, and thus the fourth transistor T4 is turned on. Accordingly, the first initialization voltage VINT is applied to the first node N1. The first initialization voltage VINT may be a sufficiently low voltage and may on-bias the first transistor T1.

Next, a scan signal of a turn-on level (a high level) is applied to the second scan line GCi, and thus the third transistor T3 is turned on. In addition, a scan signal of a turn-on level (a low level) is applied to the first scan line GWi, and thus the second transistor T2 is turned on.

Therefore, a data voltage of the data line VDj may be applied to the first node N1 through the second transistor T2, the first transistor T1, and the third transistor T3 that are in a turn-on state. At this time, a voltage of the first node N1 may be a compensation voltage obtained by subtracting a threshold voltage of the first transistor T1 from the data voltage. The storage capacitor Cst may maintain a difference between the first power voltage ELVDD and the compensation voltage.

Next, a scan signal of a turn-on level (a low level) is applied to the fourth scan line GBi, and thus the seventh transistor T7 and the eighth transistor T8 are turned on. As the seventh transistor T7 is turned on, the second initialization voltage VAINT may be applied to the anode of the light emitting element LD, and the light emitting element LD may be initialized to a charge amount corresponding to a voltage difference between the second initialization voltage VAINT and the second power voltage ELVSS. Accordingly, a low grayscale expression of the light emitting element LD may be facilitated. In addition, as the eighth transistor T8 is turned on, a voltage of the second node N2 may be set to the bias voltage VOBS.

Next, an emission signal of a turn-on level (a low level) is applied to the emission line EMi, and thus the fifth transistor T5 and the sixth transistor T6 may be turned on. Accordingly, a path of a driving current flowing from the first power voltage ELVDD to the second power voltage ELVSS via the fifth transistor T5, the first transistor T1, the sixth transistor T6, and the light emitting element LD is formed.

A driving current amount may be adjusted according to a voltage maintained in the storage capacitor Cst. The light emitting element LD emits light with a luminance corresponding to the driving current amount. The light emitting element LD may emit light until an emission signal of a turn-off level is applied to the emission line EMi.

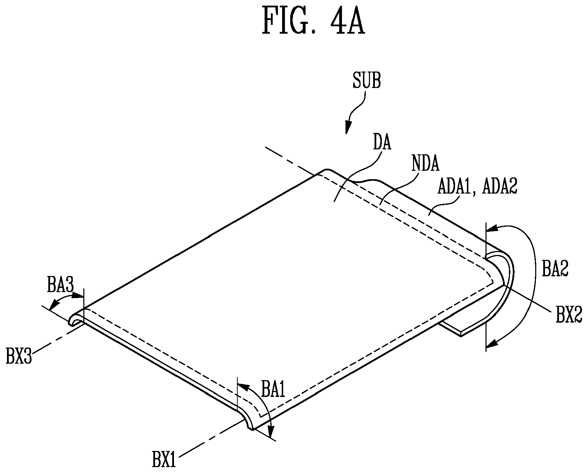

FIGS. 4A to 4C are diagrams illustrating a structure of a display panel according to an embodiment of the disclosure.

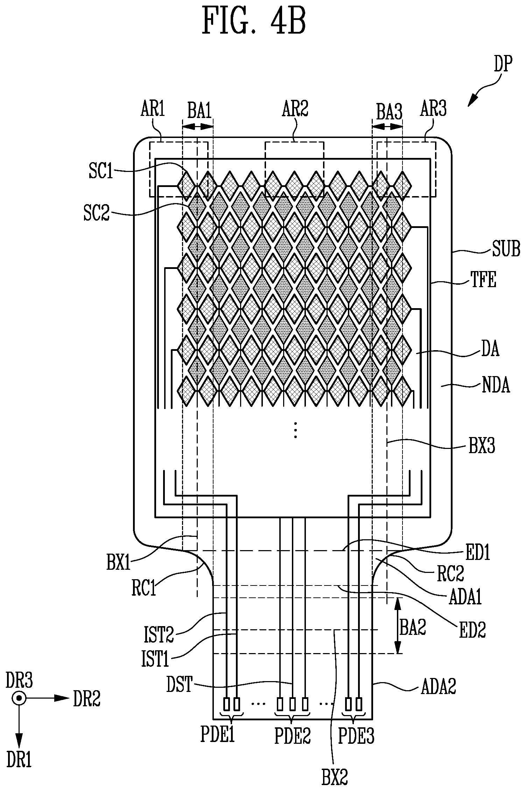

FIG. 4A is a diagram illustrating a substrate SUB according to an embodiment of the disclosure. FIG. 4B is a diagram illustrating a display panel DP according to an embodiment of the disclosure.

The substrate SUB may include a display area DA, a non-display area NDA, a first additional area ADA1, and a second additional area ADA2.

The display area DA may have a rectangular shape. Each corner of the display area DA may have an angled shape or a curved surface shape. In addition, in a case of a circular display, the display area DA may have a circular shape. In addition, the display area DA may be configured in a shape other than a quadrangular shape, such as a polygonal shape or an elliptical shape. As described above, a shape of the display area DA may be set differently according to a product.

Pixels may be positioned on the display area DA. According to a type of display panel DP, each pixel may include a light emitting diode or a liquid crystal layer.

The non-display area NDA may surround an outside of the display area DA. For example, the non-display area NDA may have a rectangular shape. Each corner of the non-display area NDA may have an angled shape or a curved surface shape. FIG. 4B is illustrated under an assumption that each corner of the non-display area NDA has a curved surface shape. The non-display area NDA may have a circular shape. Since minimizing the non-display area NDA is advantageous to a narrow bezel structure, a shape of the non-display area NDA may be similar to a shape of the display area DA.

The first additional area ADA1 may be positioned between the non-display area NDA and the second additional area ADA2. The first additional area ADA1 may be connected to the non-display area NDA at a first boundary ED1. The first additional area ADA1 may be connected to the second additional area ADA2 at a second boundary ED2. Each of the first boundary ED1 and the second boundary ED2 may extend in the second direction DR2.

A width of the first additional area ADA1 may become narrower from the first boundary ED1 to the second boundary ED2. That is, the width of the second direction DR2 of the first additional area ADA1 may become narrower toward the first direction DR1. Accordingly, the first additional area ADA1 may include curved first side surface RC1 and second side surface RC2. The side surfaces RC1 and RC2 may be convex toward an inside of the substrate SUB (for example, a center of the substrate SUB).

In FIG. 4B, the first additional area ADA1 is shown to include two side surfaces RC1 and RC2 in the second direction DR2 and an opposite direction thereof. In an embodiment, the first additional area ADA1 may include only the first side surface RC1 because the boundary positioned in the second direction DR2 coincides with a boundary of the non-display area NDA. In an embodiment, the first additional area ADA1 may include only the second side surface RC2 because a boundary positioned in the direction opposite to the second direction DR2 coincides with the boundary of the non-display area NDA.

The second additional area ADA2 may have a rectangular shape. Each corner positioned in the first direction DR1 of the second additional area ADA2 may have an angled shape or a curved surface shape.

An encapsulation layer TFE may be positioned on, e.g. directly on, the pixels. For example, the encapsulation layer TFE may cover the pixels in the display area DA, and a boundary of the encapsulation layer TFE may be positioned in the non-display area NDA. The encapsulation layer TFE may cover the light emitting elements and circuit elements of the pixels in the display area DA, thereby preventing damage from external moisture or impact.

Sensing electrodes SC1 and SC2 may be positioned on, e.g. directly on, the encapsulation layer TFE. The sensing electrodes SC1 and SC2 may sense touch, hovering, gesture, proximity-or-not, and the like by a user's body. The sensing electrodes SC1 and SC2 may be configured in a shape that varies according to various types, such as a resistive type, a capacitive type, an electro-magnetic type (EM), and an optical type. For example, when the sensing electrodes SC1 and SC2 are configured as the capacitive type, the sensing electrodes SC1 and SC2 may be configured in a self-capacitive type, a mutual-capacitive type, or the like. Hereinafter, for convenience of description, a case where the sensing electrodes SC1 and SC2 are configured in the mutual-capacitive type is described as an example.

When the sensing electrodes SC1 and SC2 are configured in the mutual-capacitive type, a driving signal may be transmitted through a sensing line corresponding to the first sensing electrode SC1, and a sensing signal may be received through a sensing line corresponding to the second sensing electrode SC2 forming a mutual capacitance with the first sensing electrode SC1. When the user's body approaches, the mutual capacitance between the first sensing electrode SC1 and the second sensing electrode SC2 may change, and according to a difference of the sensing signal according thereto, touch-or-not of a user may be detected. In an embodiment, the driving signal may be transmitted through the sensing line corresponding to the second sensing electrode SC2, and the sensing signal may be received through the sensing line corresponding to the first sensing electrode SC1 forming the mutual capacitance with the second sensing electrode SC2.

Pads PDE1, PDE2, and PDE3 may be positioned on the second additional area ADA2. The pads PDE1, PDE3 may be connected to the sensing electrodes SC1 and SC2 positioned on, e.g. directly on, the encapsulation layer through sensing lines IST1 and IST2. The pads PDE1 and PDE3 may be connected to an external touch integrated chip IC. In addition, the pads PDE2 may be connected to pixels positioned under the encapsulation layer TFE or a driver of the pixels through display lines DST. The driver may include a scan driver, an emission driver, a data driver, and the like. The driver may be positioned under the encapsulation layer TFE or may be positioned on an external display IC connected through pads PDE2.

In a case of the mutual-capacitive type, the touch IC may transmit the driving signal through the first sensing line IST1 and receive the sensing signal through the second sensing line IST2. In an embodiment, the driving signal may be transmitted through the second sensing line IST2 and the sensing signal may be received through the first sensing line IST1. For reference, in a case of the self-capacitive type, a difference may not exist in a driving method of the first sensing line IST1 and the second sensing line IST2. The display lines DST may include a control line, a data line, a power line, and the like, and may provide signals so that the pixels may display an image. The signals may be provided from the driver connected to the display lines DST.

FIG. 4A is a state in which the substrate SUB is bent, and FIG. 4B is a state in which the substrate SUB in not bent. The display panel DP may be bent as shown in FIG. 4A after elements are stacked on the substrate SUB from the state in which the substrate SUB is not bent as shown in FIG. 4B.

The substrate SUB may include a first bending area BA1 extending to overlap the non-display area NDA from the first side surface RC1 of the first additional area ADA1. In addition, the first bending area BA1 may extend to overlap the display area DA. That is, each of the display area DA, the non-display area NDA, and the first additional area ADA1 may partially overlap the first bending area BA1. The first bending area BA1 may have a width of the second direction DR2, and a length may extend in the first direction DR1. A first bending axis BX1 may be defined as a folding line extending in the first direction DR1 from a center of the first bending area BA1. According to an embodiment, the first bending area BA1 may be a portion where stress is reduced by removing a partial insulating layer or the like differently from another peripheral portion. According to an embodiment, the first bending area BA1 may have the same configuration as the other peripheral portion.

The substrate SUB may include a third bending area BA3 extending to overlap the non-display area NDA from the second side surface RC2 of the first additional area ADA1. In addition, the third bending area BA3 may extend to overlap the display area DA. That is, each of the display area DA, the non-display area NDA, and the first additional area ADA1 may partially overlap the third bending area BA3. The third bending area BA3 may have a width of the second direction DR2 and a length may extend in the first direction DR1. A third bending axis BX3 may be defined as a fold line extending in the first direction DR1 from a center of the third bending area BA3. According to an embodiment, the third bending area BA3 may be a portion where stress is reduced by removing a partial insulating layer or the like differently from another peripheral portion. According to an embodiment, the third bending area BA3 may have the same configuration as the other peripheral portion.

The second additional area ADA2 may include a second bending area BA2. The second bending area BA2 may have a width of the first direction DR1 and a length may extend in the second direction DR2. The second bending axis BX2 may be defined as a fold line extending in the second direction DR2 from a center of the second bending area BA2. According to an embodiment, the second bending area BA2 may be a portion where stress is reduced by removing a partial insulating layer or the like differently from another peripheral portion. According to an embodiment, the second bending area BA2 may have the same configuration as the other peripheral portion.

The first to third bending areas BA1, BA2, and BA3 may not overlap each other.

Here, the term "folded" means that a shape is not fixed, but may be transformed from an original shape to another shape, and may include being folded, curved, or rolled along one or more bending axes. A side surface bezel width of the second direction DR2 and the direction opposite to the second direction DR2 of the display panel DP may be reduced by the first and third bending areas BA1 and BA3. In addition, a side surface bezel width of the first direction DR1 of the display panel DP may be reduced by the second bending area BA2.

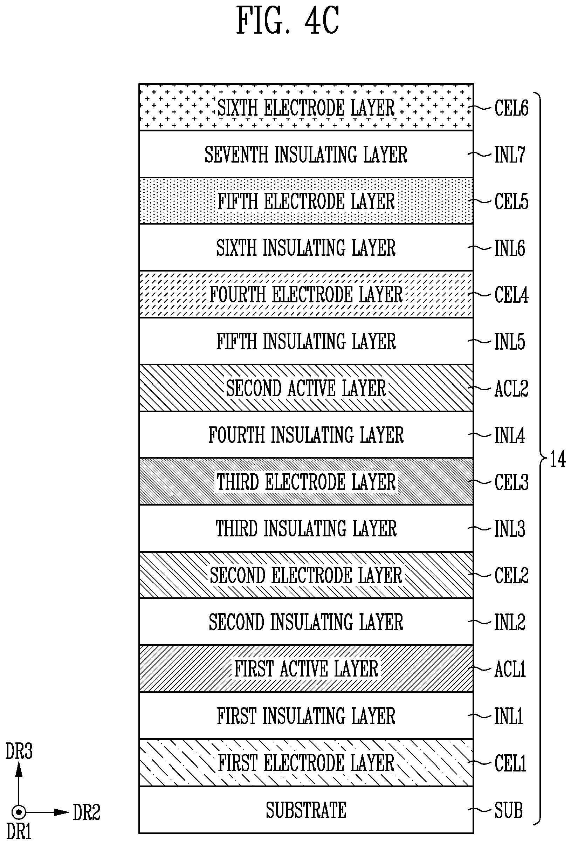

FIG. 4C is a diagram illustrating a stack structure of a pixel unit according to an embodiment of the disclosure.

Referring to FIG. 4C, the pixel unit 14 may have a structure in which a substrate SUB, a first electrode layer CEL1, a first insulating layer INL1, a first active layer ACL1, a second insulating layer INL2, a second electrode layer CEL2, a third insulating layer INL3, a third electrode layer CEL3, a fourth insulating layer INL4, a second active layer ACL2, a fifth insulating layer INL5, a fourth electrode layer CEL4, a sixth insulating layer INL6, a fifth electrode layer CEL5, a seventh insulating layer INL7, and a sixth electrode layer CEL6 are sequentially stacked. However, the pixel unit is not limited to the stack structure. For example, the layers may be arranged in a different order and/or some of the layers may be omitted.

The substrate SUB may be formed of various materials such as glass, polymer, and metal. The substrate SUB may be selected as one of a rigid substrate and a flexible substrate, according to an application product. When the substrate SUB is configured to include a polymer organic material, the substrate SUB may be configured of polystyrene, polyvinyl alcohol, polymethyl methacrylate, polyethersulfone, poly polyacrylate, polyetherimide, polyethylene naphthalate, polyethylene terephthalate, polyphenylene sulfide, polyarylate, polyimide, polycarbonate, triacetate cellulose, cellulose acetate propionate, or the like. On the other hand, the substrate SUB may be formed of fiber glass reinforced plastic (FRP).

The first active layer ACL1 and the second active layer ACL2 may be semiconductor layers. For example, the first active layer ACL1 may be configured of a polysilicon semiconductor, and the second active layer ACL2 may be configured of an oxide semiconductor. The first active layer ACL1 may include a channel, a first electrode, and a second electrode of the polysilicon semiconductor transistors T1, T2, T5, T6, T7, and T8. The second active layer ACL2 may include a channel, a first electrode, and a second electrode of the oxide semiconductor transistors T3 and T4. The first electrode and the second electrodes of each of transistors T1 to T8 may be doped with an impurity for conduction.

The first electrode layer CEL1, the second electrode layer CEL2, the third electrode layer CEL3, the fourth electrode layer CEL4, the fifth electrode layer CEL5, and the sixth electrode layer CEL6 may be conductive layers. Each electrode layer may be configured of a single layer or multiple layers, and may be configured of a known conductor such as gold (Au), silver (Ag), aluminum (Al), molybdenum (Mo), chromium (Cr), titanium (Ti), nickel (Ni), neodymium (Nd), copper (Cu), and platinum (Pt).

The first insulating layer INL1, the second insulating layer INL2, the third insulating layer INL3, the fourth insulating layer INL4, the fifth insulating layer INL5, the sixth insulating layer INL6, and the seventh insulating layer INL7 may be interposed to electrically separate the active layers ACL1 and ACL2 and the first to sixth electrode layers CEL1, CEL2, CEL3, CEL4, CEL5, and CEL6. Necessary electrode patterns may be connected to each other through contact holes formed in each of the insulating layers INL1, INL2, INL3, INL4, INL5, INL6, and INL7. The insulating layers INL1, INL2, INL3, INL4, INL5, INL6, and INL7 may be configured of an organic insulating layer, an inorganic insulating layer, an organic/inorganic insulating layer, or the like and may be configured of a single layer or multiple layers. For example, the insulating layers INL1, INL2, INL3, INL4, INL5, INL6, and INL7 may include at least one of silicon nitride (SiNx), silicon oxide (SiOx), silicon oxynitride (SiOxNy), acryl resin, epoxy resin, phenolic resin, polyamide resin, and polyimide resin.

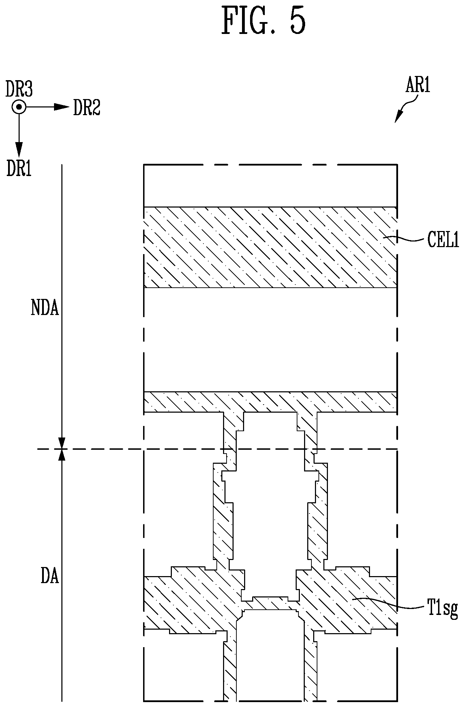

Hereinafter, in FIGS. 5 to 17, the insulating layers INL1, INL2, INL3, INL4, INL5, INL6, and INL7 are not shown separately.

FIGS. 5 to 14 are diagrams illustrating a first area AR1 of a pixel unit according to an embodiment of the disclosure.

Referring to FIG. 4B again, the substrate SUB may include the first area AR1, a second area AR2, and a third area AR3. The first area AR1, the second area AR2, and the third area AR3 may be areas positioned at an edge of the substrate SUB (for example, an edge positioned in a direction opposite to the first direction DR1 from a center of the substrate SUB). The first area AR1 may be an area adjacent to a first corner of the substrate SUB, and the third area AR3 may be an area adjacent to a second corner of the substrate SUB. The second area AR2 may be an area positioned between the first area AR1 and the third area AR3. Pixels positioned in the first area AR1, the second area AR2, and the third area AR3 may be referred to as outer pixels. The outer pixels may indicate pixels positioned closest to the edge of the substrate SUB. For example, the outer pixels may be pixels having the smallest distance in the first direction DR1 from the edge of the substrate SUB.

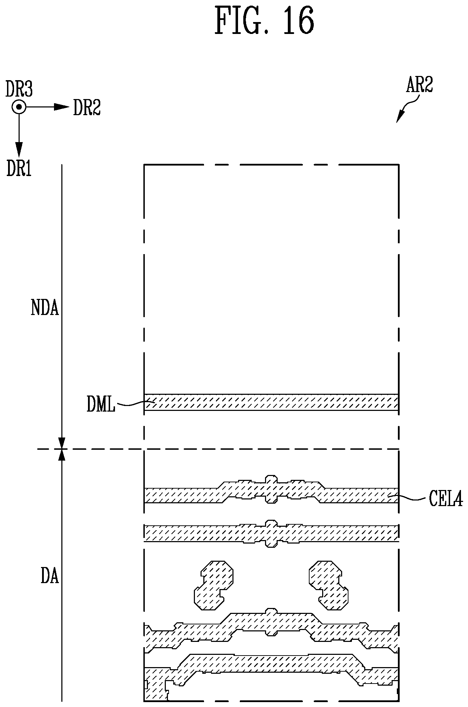

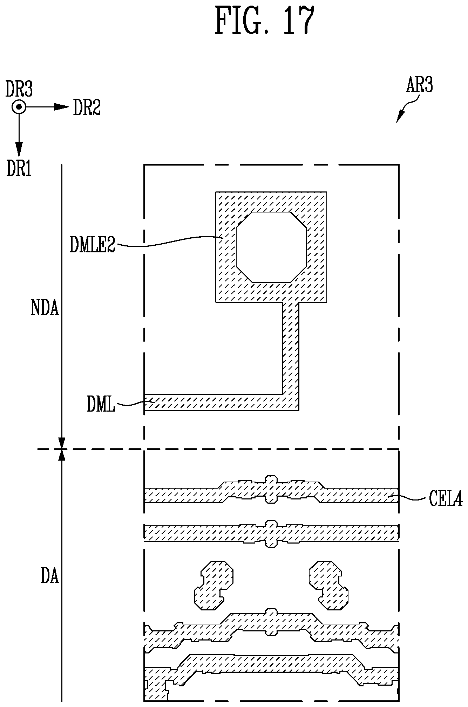

FIGS. 5 to 14 are described based on the first area AR1. Since a configuration of the second area AR2 and the third area AR3 is similar to that of the first area AR1, an overlapping description is omitted. A difference between the first area AR1, the second area AR2, and the third area AR3 is described later with reference to FIGS. 16 and 17.

Referring to FIG. 5, exemplary patterns of the first electrode layer CEL1 are shown. A partial pattern of the first electrode layer CEL1 may configure a sub-gate electrode T1sg of the first transistor T1.

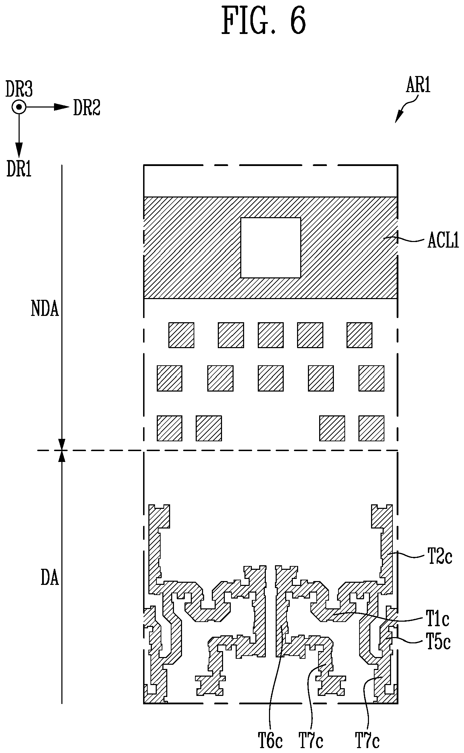

Referring to FIG. 6, exemplary patterns of the first active layer ACL1 are shown. The first active layer ACL1 may include channels T1c, T2c, T5c, T6c, T7c, and T8c of the transistors T1, T2, T5, T6, T7, and T8. Each of portions of the first active layer ACL1 spaced apart with a channel interposed therebetween may configure the first electrode and the second electrode of the transistors T1, T2, T5, T6, T7, and T8.

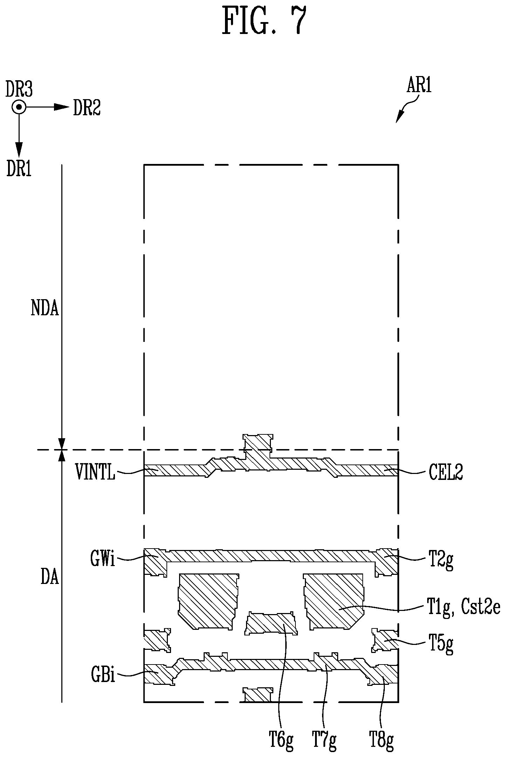

Referring to FIG. 7, exemplary patterns of the second electrode layer CEL2 are shown. The second electrode layer CEL2 may include gate electrodes T1g, T2g, T5g, T6g, T7g, and T8g of the transistors T1, T2, T5, T6, T7, and T8. The gate electrodes T1g, T2g, T5g, T6g, T7g, and T8g may overlap the channels T1c, T2c, T5c, T6c, T7c, and T8c in the third direction DR3.

In addition, some patterns of the second electrode layer CEL2 may configure the first scan line GWi, the fourth scan line GBi, a first initialization line VINTL, and a second electrode Cst2e of the storage capacitor Cst. The first initialization voltage VINT may be applied to the first initialization line VINTL.

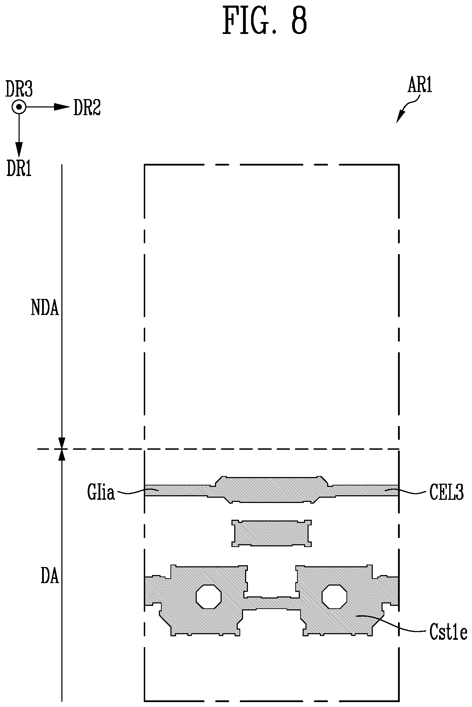

Referring to FIG. 8, exemplary patterns of the third electrode layer CEL3 are shown. Some patterns of the third electrode layer CEL3 may configure a third scan line Glia and a first electrode Cst1e of the storage capacitor Cst. The third scan line Glia may be a sub-scan line connected to the fourth transistor T4. The sub-scan line may be connected to the sub-gate electrode (or the back gate electrode) of the fourth transistor T4.

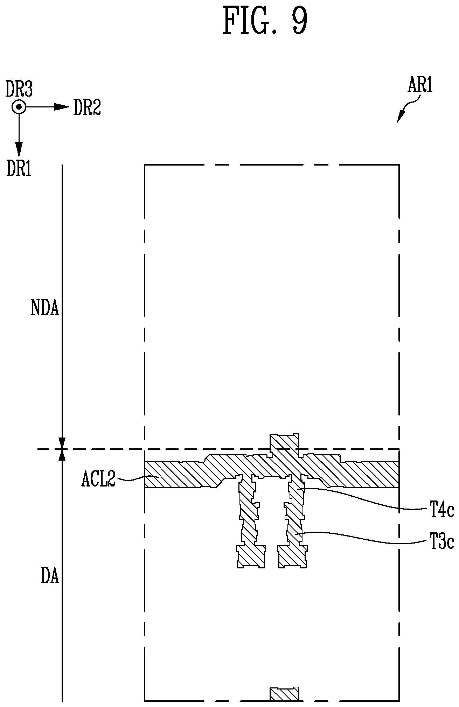

Referring to FIG. 9, exemplary patterns of the second active layer ACL2 are shown. The second active layer ACL2 may include channels T3c and T4c of the transistors T3 and T4. Each of portions of the second active layer ACL2 spaced apart with a channel interposed therebetween may configure the first electrode and the second electrode of the transistors T3 and T4.

The fourth transistor T4, which is an oxide semiconductor transistor, may be a transistor positioned closest to the edge of the substrate SUB among the transistors T1 to T8 of the outer pixel.

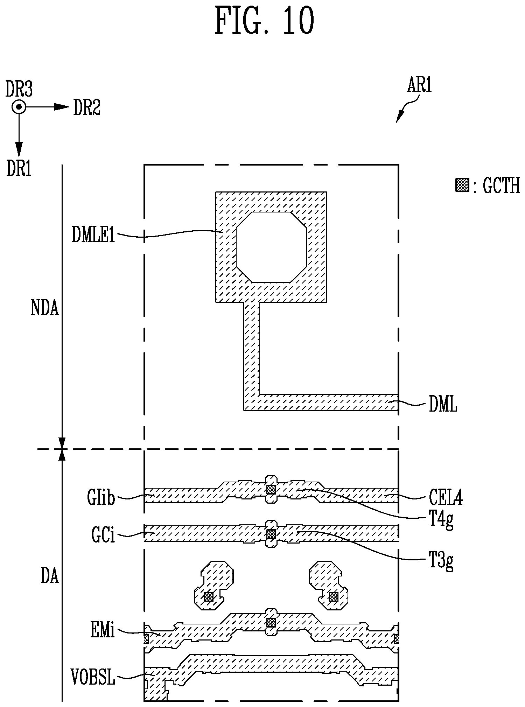

Referring to FIG. 10, exemplary patterns of the fourth electrode layer CEL4 are shown. The fourth electrode layer CEL4 may include gate electrodes T3g and T4g of the transistors T3 and T4. The gate electrodes T3g and T4g may overlap the channels T3c and T4c in the third direction DR3.

In addition, some patterns of the fourth electrode layer CEL4 may configure the second scan line GCi, the third scan line Glib, the emission line EMi, the bias line VOBSL, and a dummy line DML. The bias voltage VOBS may be applied to the bias line VOBSL.

First contact holes GCTH may be holes etched to connect patterns of the fourth electrode layer CEL4 to an electrode layer or an active layer under the patterns.

The dummy line DML may be positioned between the edge of the substrate SUB and the outer pixels. The dummy line DML is positioned in the non-display area NDA.

Referring to FIGS. 10, 16, and 17, the dummy line DML may extend in the second direction DR2 across the first area AR1, the second area AR2, and the third area AR3. One end DMLE1 of the dummy line DML may be positioned in the first area AR1. Another end DMLE2 of the dummy line DML may be positioned in the third area AR3.

It may be seen that the third scan line Glib connected to the fourth transistor T4, which is an oxide semiconductor transistor, is positioned in the same electrode layer as the dummy line DML. A vertical distance between the third scan line Glib connected to the fourth transistor T4 and the substrate SUB may be the largest among vertical distances between the scan lines GWi, GBi, Glia, Glib, and GCi connected to the outer pixels and the substrate SUB. That is, the fourth electrode layer CEL4 may be positioned above (that is, in the third direction DR3) the second and third electrode layers CEL2 and CEL3.

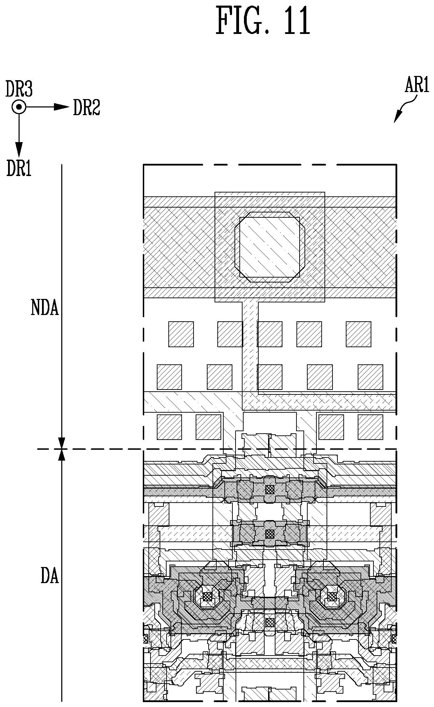

Referring to FIG. 11, a layout in which FIGS. 5 to 10 are overlapped is shown.

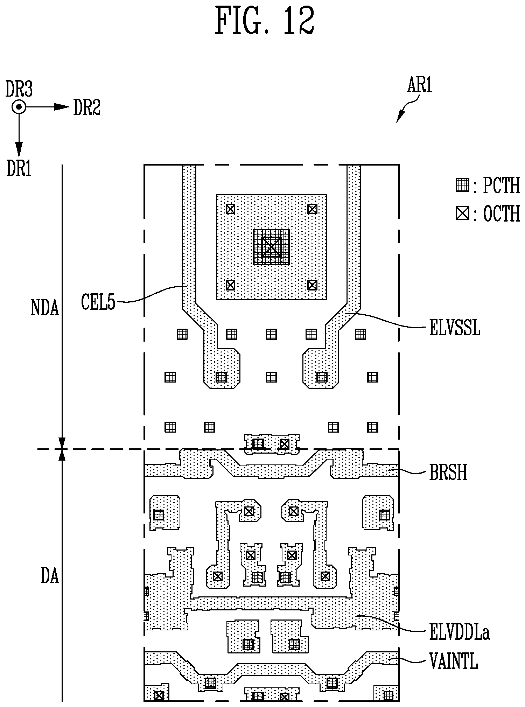

Referring to FIG. 12, exemplary patterns of the fifth electrode layer CEL5 are shown.

Some patterns of the fifth electrode layer CEL5 may configure a first power line ELVDDLa, the second power line ELVSSL, a horizontal bridge line BRSH, and a second initialization line VAINTL. The second initialization voltage VAINT may be applied to the second initialization line VAINTL. The first power voltage ELVDD may be applied to the first power line ELVDDLa. The second power voltage ELVSS may be applied to the second power line ELVSSL.

The data driver 12 (or the timing controller 11), the scan driver 13, and the emission driver 15 may be configured in a form of an IC, and signal lines of the data driver 12 may be locally connected to pad electrodes of the pixel unit 14. The horizontal bridge line BRSH may serve as a bridge so that dense lines connected to the pad electrodes may be widely spread and connected throughout the pixel unit 14.

Second contact holes PCTH may be holes etched to connect patterns of the fifth electrode layer CEL5 to an electrode layer or the first active layer ACL1 under the patterns. Some of the second contact holes PCTH may be dummy holes. The dummy holes may not be holes for an electrical connection, but may function as a passage for hydrogen discharge. The dummy holes may be positioned in the non-display area NDA.

Third contact holes OCTH may be holes etched to connect the patterns of the fifth electrode layer CEL5 to the electrode layer or the second active layer ACL2 under the patterns.

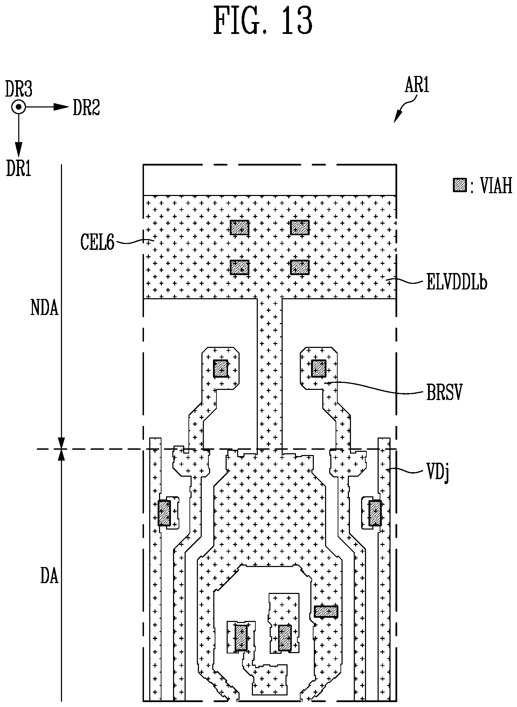

Referring to FIG. 13, exemplary patterns of the sixth electrode layer CEL6 are shown. Some patterns of the sixth electrode layer CEL6 may configure a first power line ELVDDLb, the data line VDj, and a vertical bridge line BRSV. The first power voltage ELVDD may be applied to the first power line ELVDDLb.

Fourth contact holes VIAH may be holes etched to connect the patterns of the sixth electrode layer CEL6 to an electrode layer or an active layer under the patterns.

The vertical bridge line BRSV may perform the same role as the horizontal bridge line BRSH. When the horizontal bridge line BRSH extends in the second direction DR2, the vertical bridge line BRSV may extend in the first direction DR1. The corresponding horizontal bridge line BRSH and vertical bridge line BRSV may be connected to each other.

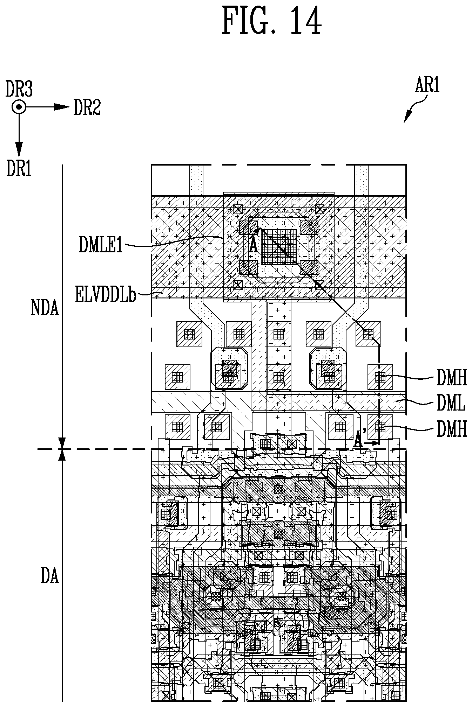

Referring to FIG. 14, a layout overlapping FIGS. 5 to 13 is shown.

Dummy holes DMH are positioned between the edge of the substrate SUB and the outer pixels. The dummy holes DMH are positioned in the non-display area NDA. The dummy holes DMH may include a portion of an upper insulating layer (for example, a seventh insulating layer INL7) therein. The dummy holes DMH may not include an electrode material therein. The dummy holes DMH may prevent diffusion of hydrogen and discharge hydrogen to an outside.

The dummy line DML extends in the second direction DR2 different from the first direction DR1 between the dummy holes DMH. The dummy line DML may be positioned between a fifth insulating layer INL5 and a sixth insulating layer INL6. The dummy holes DMH may pass through the fifth insulating layer INL5 and the sixth insulating layer INL6. The dummy holes DMH and the dummy line DML may not overlap each other in the third direction DR3 so that the dummy line DML is not damaged when the dummy holes DMH are etched.

The dummy line DML may be connected to the first power line ELVDDLb. For example, one end DMLE1 of the dummy line DML may be connected to the first power line ELVDDLb in an area (for example, the first area AR1) adjacent to the first corner of the substrate SUB. The first power line ELVDDLb may be positioned between the edge of the substrate SUB and a dummy hole closest to the edge of the substrate SUB among the dummy holes DMH, and may extend in the second direction DR2.

The dummy line DML to which the first power voltage ELVDD is applied may perform a hydrogen adsorption function. Therefore, diffusion of hydrogen may be prevented and conduction of a transistor channel may be prevented.

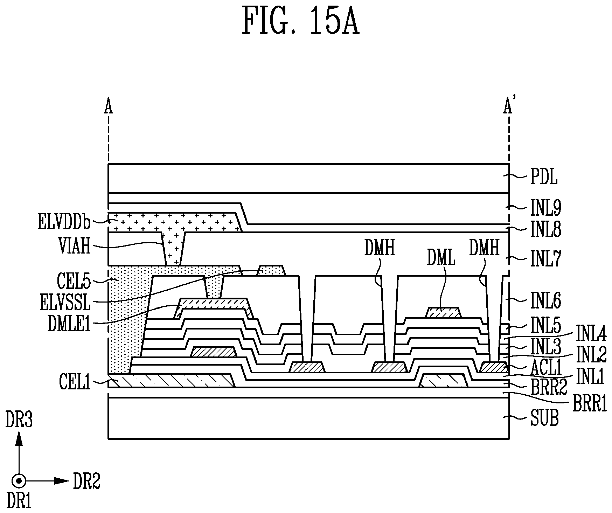

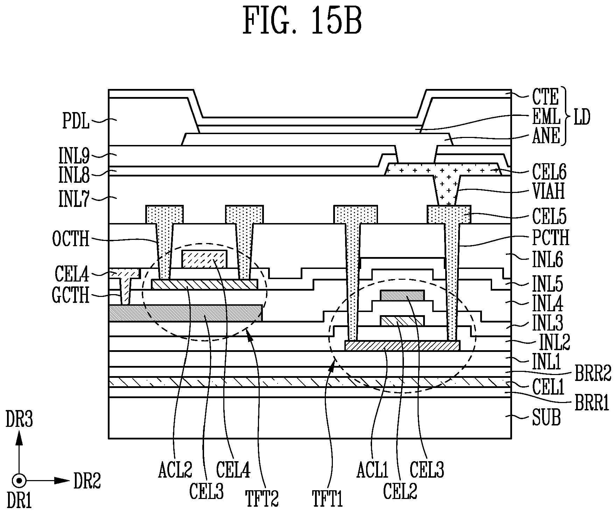

FIGS. 15A and 15B are cross-sectional views of a non-display area NDA and a display area DA according to an embodiment of the disclosure.

FIG. 15A is a cross-sectional view taken along a line A-A' in the non-display area NDA of FIG. 14. FIG. 15B is an exemplary cross-sectional view of an arbitrary polysilicon semiconductor transistor TFT1, an oxide semiconductor transistor TFT2, and the light emitting element LD in the display area DA. When describing FIGS. 15A and 15B, a content overlapping that described with FIGS. 4C to 14 is omitted.

A first barrier layer BRR1 may be positioned between the substrate SUB and the first electrode layer CEL1. A second barrier layer BRR2 may be positioned between the first electrode layer CEL1 and the first insulating layer INL1. The barrier layers BRR1, BRR2 may block an unnecessary component such as moisture and/or oxygen from entering from the outside. The barrier layers BRR1 and BRR2 may be configured of the same or similar material as the above-described insulating layers.

A single insulating layer or a plurality of insulating layers INL8 and INL9 may be positioned on, e.g. directly on, the sixth electrode layer CEL6.

The light emitting element LD may include an anode electrode ANE, a light emitting layer EML, and a cathode electrode CTE.

The anode electrode ANE may be positioned on, e.g. directly on, the insulating layer INL9 and may be connected to a partial pattern of the sixth electrode layer CEL6 through a contact hole. The anode electrode ANE may be formed of a metal layer such as Ag, Mg, Al, Pt, Pd, Au, Ni, Nd, Ir, Cr, and an alloy thereof, indium tin oxide (ITO), indium zinc oxide (IZO), zinc oxide (ZnO), indium tin zinc oxide (ITZO), and/or the like. The anode electrode ANE may be formed of one type of metal, but is not limited thereto and may be formed of an alloy of two or more types of metals, for example, Ag and Mg.

The anode electrode ANE may be formed of a transparent conductive layer when an image is desired to be provided in a lower direction of the substrate SUB, and may be formed of a metal reflective layer and/or a transparent conductive layer when an image is desired to be provided in an upper direction of the substrate SUB.

A pixel defining layer PDL partitioning an emission area of each pixel is provided on the substrate SUB on which the anode electrode ANE is formed. The pixel defining layer PDL may be an organic insulating layer formed of an organic material. As the organic material, an organic insulating material such as a polyacrylic compound, a polyimide compound, a fluorine-based carbon compound such as Teflon, and a benzocyclobutene compound may be used.

The pixel defining layer PDL may expose an upper surface of the anode electrode ANE and may protrude from the substrate SUB along a circumference of the pixel. The light emitting layer EML may be provided in a pixel area surrounded by the pixel defining layer PDL.

The light emitting layer EML may include a low molecular or high molecular material. The low molecular material may include copper phthalocyanine (CuPc), N,N-di(naphthalene-1-yl)-N,N'-diphenyl-benzidine (N,N'-Di(naphthalene-1-yl)-N,N'-diphenyl-benzidine (NPB), tris-8-hydroxyquinoline aluminum (Alq3), and the like. These materials may be formed in a vacuum deposition method. The high molecular material may include PEDOT, poly-phenylenevinylene (PPV), and polyfluorene.

The light emitting layer EML may be provided as a single layer, but may be provided as multiple layers including various functional layers. When the light emitting layer EML is provided as multiple layers, the light emitting layer EML has a structure in which a hole injection layer (HIL), a hole transport layer (HTL), an emission layer (EML), an electron transport layer (ETL), an electron injection layer (EIL), and the like are stacked in a single or complex structure. The light emitting layer EML may be formed in a screen printing or inkjet printing method, a laser induced thermal imaging (LITI), or the like.

According to an embodiment, at least a portion of the light emitting layer EML may be integrally formed across a plurality of anode electrodes ANE, and may be provided individually to correspond to each of the plurality of anode electrodes ANE.

The cathode electrode CTE may be provided on the light emitting layer EML. The cathode electrode CTE may be provided for each pixel, but may be provided to cover most of the display area DA and may be shared by a plurality of pixels.

The cathode electrode CTE may be formed of a metal layer such as Ag, Mg, Al, Pt, Pd, Au, Ni, Nd, Ir, and Cr, a transparent conductive layer such as indium tin oxide (ITO), indium zinc oxide (IZO), zinc oxide (ZnO), and indium tin zinc oxide (ITZO), and the like. In an embodiment of the disclosure, the cathode electrode CTE may be formed as multiple layers of double or more layers including a metal thin film, for example, may be formed as triple layers of ITO/Ag/ITO.

The cathode electrode CTE may be formed of a metal reflective layer and/or a transparent conductive layer when an image is desired to be provided in a lower direction of the substrate SUB, and may be formed of a transparent conductive layer when an image is desired to be provided in an upper direction of the substrate SUB.

FIG. 16 is a diagram illustrating the second area AR2 of a pixel unit according to an embodiment of the disclosure. In FIG. 16, the second area AR2 of the fourth electrode layer CEL4 is shown.

Other portions of the dummy line DML except for the one end DMLE1 and the other end DMLE2 may not be connected to the first power line ELVDDLb. That is, in the second area AR2, the dummy line DML may not be connected to the first power line ELVDDLb. According to the present embodiment, an overlap of the dummy line DML with the second power line ELVSSL shown in FIG. 12 may be minimized.

FIG. 17 is a diagram illustrating the third area AR3 of a pixel unit according to an embodiment of the disclosure. In FIG. 17, the third area AR3 of the fourth electrode layer CEL4 is shown.

The other end DMLE2 of the dummy line DML may be connected to the first power line ELVDDLb in an area adjacent to the second corner of the substrate SUB (for example, the third area AR3).

For example, when the other end DMLE2 of the dummy line DML is not connected to the first power line ELVDDLb, a voltage deviation may occur between the one end DMLE1 and the other end DMLE2 of the dummy line DML due to an IR drop phenomenon. According to the present embodiment, the first power voltage ELVDD may be uniformly applied to the dummy line DML.

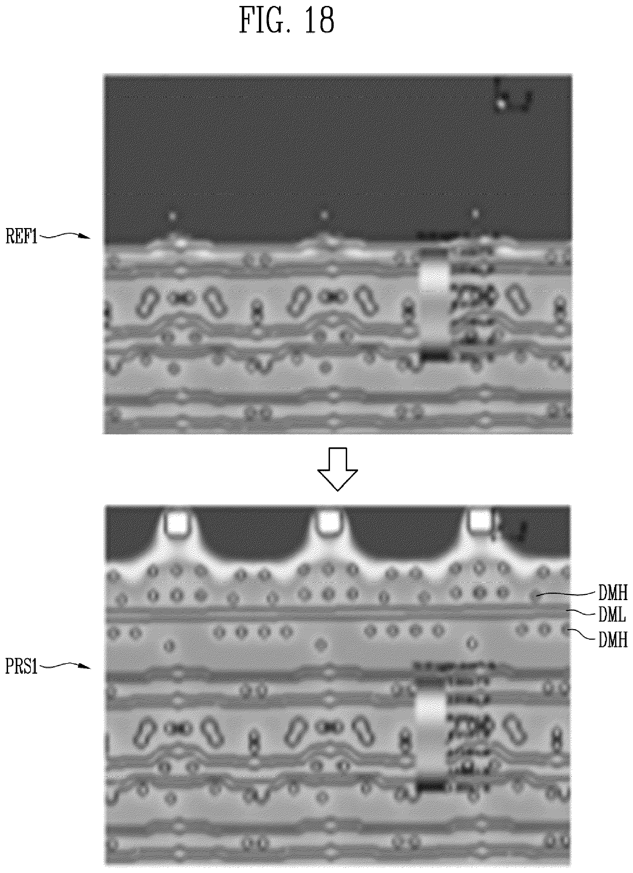

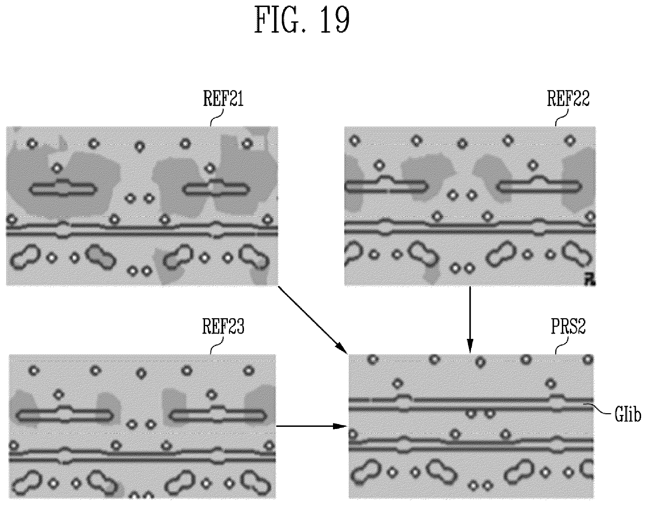

FIGS. 18 and 19 are diagrams illustrating an effect of hydrogen diffusion prevention according to an embodiment of the disclosure.

Referring to FIG. 18, results of a comparison object simulation REF1 and a simulation PRS1 to which an embodiment of the disclosure is applied may be seen.

In the simulation REF1 without the dummy line DML, it may be seen that hydrogen (an upper portion stain of a layout) invades and is diffused to an area of the pixel circuit.

On the other hand, referring to the simulation PRS1 according to an embodiment of the disclosure, it may be seen that hydrogen is not diffused on the dummy line DML extending between the dummy holes DMH.

Referring to FIG. 19, results of comparison object simulations REF21, REF22, and REF23 and a simulation PRS2 to which an embodiment of the disclosure is applied may be seen.

In the comparison object simulations REF21, REF22, and REF23, the third scan line Glib is configured in an island shape in the fourth electrode layer CEL4. On the other hand, in the simulation PRS2 to which an embodiment of the disclosure is applied, the third scan line Glib is configured in a line shape in the fourth electrode layer CEL4.

When comparing the results of the simulations, it may be seen that diffusion of hydrogen (stains of a layout) is the smallest in the simulation PRS2 to which an embodiment of the disclosure is applied.

The drawings referred to so far and the detailed description of the disclosure described herein are merely examples of the disclosure, are used for merely describing the disclosure, and are not intended to limit the meaning and the scope of the disclosure described in claims. Therefore, those skilled in the art will understand that various modifications and equivalent other embodiments are possible from these. Thus, the true scope of the disclosure should be determined by the scope of the appended claims.

## Claims

1. A display device (10) comprising:
a substrate (SUB) including a display area (DA) and a non-display area (NDA);
outer pixels positioned in the display area (DA) and positioned in a first direction (D1) from an edge of the substrate (SUB);
dummy holes (DMH) positioned in the non-display area (NDA) and positioned between the edge of the substrate (SUB) and the outer pixels; and
a dummy line (DML) positioned in the non-display area (NDA) and extending in a second direction (DR2) different from the first direction (DR1) between the dummy holes (DMH),
wherein the dummy line (DML) is positioned between a first insulating layer (INL5) and a second insulating layer (INL6), and
the dummy holes (DMH) pass through the first insulating layer (INL5) and the second insulating layer (INL6).

2. The display device (10) according to claim 1, further comprising:
a third insulating layer (INL7) positioned on the second insulating layer (INL6),
wherein the dummy holes (DMH) include a portion of the third insulating layer (INL7) therein.

3. The display device (10) according to claim 1 or 2, wherein the dummy holes (DMH) do not include an electrode material therein.

4. The display device (10) according to any one of the preceding claims, wherein one end (DMLE1) of the dummy line (DML) is connected to a first power line (ELVDDLb) in an area adjacent to a first corner of the substrate (SUB), and
an other end (DMLE2) of the dummy line (DML) is connected to the first power line (ELVDDLb) in an area adjacent to a second corner of the substrate (SUB).

5. The display device (10) according to claim 4, wherein other portions of the dummy line (DML) except the one end (DMLE1) of the dummy line (DML) and the other end (DMLE2) of the dummy line (DML) are not connected to the first power line (ELVDDLb).

6. The display device (10) according to claim 4 or 5, wherein the first power line (ELVDDLb) is positioned between the edge of the substrate (SUB) and a dummy hole (DMH) closest to the edge among the dummy holes (DMH), and extends in the second direction (DR2).

7. The display device (10) according to any one of the preceding claims, wherein each of the outer pixels includes transistors, and
at least one of the transistors is an oxide semiconductor transistor.

8. The display device (10) according to claim 7, wherein the oxide semiconductor transistor is a transistor positioned most adjacent to the edge of the substrate (SUB) among the transistors.

9. The display device (10) according to claim 8, wherein a scan line connected to the oxide semiconductor transistor is positioned in a same electrode layer as the dummy line (DML).

10. The display device (10) according to claim 9, wherein the oxide semiconductor transistor is further connected to a sub-scan line that overlaps the scan line.

11. The display device (10) according to claim 9 or 10, wherein a distance between the scan line connected to the oxide semiconductor transistor and the substrate (SUB) in a third direction (DR3) arranged orthogonally with respect to the first direction (DR1) and the second direction (DR2) is the largest among distances in the third direction (DR3) between scan lines connected to the outer pixels and the substrate (SUB).

12. The display device (10) according to any one of the preceding claims, wherein the dummy line (DML) extends so as not to overlap the dummy holes (DMH) in a third direction (DR3) arranged orthogonally with respect to the first direction (DR1) and the second direction (DR2).

13. The display device (10) according to any one of the preceding claims, wherein the dummy holes (DMH) are configured to discharge hydrogen to an outside.

14. The display device (10) according to any one of the preceding claims, further comprising a first barrier layer (BRR1) and/or second barrier layer (BRR2) configured to block moisture and/or oxygen from entering from the outside.

15. The display device (10) according to claim 14, wherein the first barrier layer (BRR1) is positioned between the substrate (SUB) and a first electrode layer (CEL1) and/or the second barrier layer (BRR2) is positioned between the first electrode layer (CEL1) and a fourth insulating layer (INL1).
